# EUROPÄISCHE PATENTANMELDUNG

(11) **EP 1 882 953 A1**
(43) Veröffentlichungstag der Anmeldung: **30.01.2008**
(21) Anmeldenummer: 06015660.1
(22) Anmeldetag: 26.07.2006
(51) Int. Cl.: G01R 15/20

(54) **Stromerfassungsvorrichtung**

(71) Anmelder: SIEMENS AKTIENGESELLSCHAFT, 80333 München (DE)
(72) Erfinder: Kaluza, Peter, 92286 Rieden (DE); Rieger, Gotthard, Dr., 91058 Erlangen (DE); Weiss, Roland, Dr., 91058 Erlangen (DE); Widmann, Christian, 92284 Poppenricht (DE)

(57) **Zusammenfassung**

Es wird eine Stromerfassungsvorrichtung mit einem als Stromsensor fungierenden Magnetfeldsensor 18 angegeben, bei der ein zur Stromerfassungsvorrichtung gehöriger Leiter 10 oder Leiterabschnitt 10, dem der Magnetfeldsensor 18 zugeordnet ist, zumindest einen Bereich umfasst, in dem ein erstes Segment 14 und ein zweites Segment 16 des Leiters oder Leiterabschnitts 10 parallel oder zumindest im Wesentlichen parallel zueinander orientiert sind, so dass sich in einem Bereich zwischen diesen beiden Segmenten 14, 16 ein leiterfreier Bereich ergibt, in dem sich bei Stromfluss durch den Leiter 10 ein Gradientenfeld ausbildet, das von dem Magnetfeldsensor 18, der räumlich sowohl diesem ersten und zweiten Segment 14, 16 zugeordnet ist, erfasst wird oder erfassbar ist.

## Beschreibung

Die Erfindung betrifft eine Stromerfassungsvorrichtung mit einem als Stromsensor fungierenden Magnetfeldsensor gemäß dem Oberbegriff des Anspruchs 1.

Derartige Stromerfassungsvorrichtungen oder Stromsensoren sind allgemein bekannt. So erfolgt die Stromerfassung bei bekannten Ansätzen z.B. mittels induktiver Stromwandler, z.B. Ringkernwandler, mittels so genannter Hall-Sensoren oder, insbesondere bei größeren Strömen, mittels so genannter Rogowski-Spulen. Nachteilig bei den im Stand der Technik bekannten Stromerfassungsvorrichtungen oder Stromsensoren ist, dass diese bisher nicht direkt mit dem jeweiligen Leiter, in dem ein Stromfluss zu messen ist, kombinierbar sind. Zudem ist eine galvanische oder sonstige sichere Trennung bisher nur durch zusätzliche Maßnahmen realisierbar.

Eine Aufgabe der Erfindung besteht entsprechend darin, eine Stromerfassungsvorrichtung oder einen Stromsensor anzugeben, der die o.g. Nachteile vermeidet oder zumindest verringert bzw. hinsichtlich ihrer Auswirkungen reduziert.

Diese Aufgabe wird erfindungsgemäß mit den Merkmalen des Anspruchs 1 gelöst. Dazu ist bei einer Stromerfassungsvorrichtung mit einem als Stromsensor fungierenden Magnetfeldsensor vorgesehen, dass der Stromerfassungsvorrichtung ein Leiter oder Leiterabschnitt zugeordnet ist, dass der Leiterabschnitt zumindest einen Bereich umfasst, in dem ein erstes Segment und ein zweites Segment parallel oder zumindest im Wesentlichen parallel zueinander orientiert sind und dass der Magnetfeldsensor räumlich diesen beiden Segmenten des Leiterabschnitts sehr nahe zugeordnet ist, so dass er von den Feldlinien des Leiterabschnitts, also insbesondere von den von den beiden Segmenten ausgehenden Feldlinien, "durchsetzt" ist.

Bevorzugt wird als Magnetfeldsensor ein MR-Sensor, bevorzugt in einer Ausführung als AMR- oder TMR-Sensor (AMR = Anisotrope Magnetoresistive effect; TMR = Tunnel Magnetoresistive effect), besonders bevorzugt in einer Ausführung GMR-Sensor (GMR = Giant Magnetoresistive effect), verwendet. Wenn im Folgenden der Magnetfeldsensor als GMR-Sensor bezeichnet ist, sind entsprechend, sofern sich aus dem Zusammenhang nichts Anderes ergibt, zumindest auch die o.g. weiteren Ausführungsformen umfasst.

Der Vorteil der Erfindung besteht darin, dass die beiden o.g. Segmente einen leiterfreien Bereich, z.B. einen Schlitz in einer Stromschiene oder dergleichen, einschließen, der von einem magnetischen Feld durchsetzt ist. Die beiden vorgenannten Segmente kann man sich schematisch vereinfacht als Schenkel eines U-förmig gebogenen Leiterabschnitts vorstellen. Entsprechend wird der die beiden Segmente umfassende Leiterabschnitt im Folgenden kurz auch als "U-Turn" bezeichnet. Bei einem Stromfluss durch diesen U-Turn ist die Richtung des Stroms im ersten Segment entgegengesetzt zur Richtung des Stroms im zweiten Segment. Entsprechend ergibt sich in dem von den beiden Segmenten eingeschlossenen leiterfreien Abschnitt nach der so genannten "Rechte-Hand-Regel" auch eine gegenläufige Orientierung der Feldlinien des magnetischen Feldes z. B. an der Oberfläche der Segmente. In dem von den beiden Segmenten eingeschlossenen leiterfreien Abschnitt bildet sich also ein Gradientenfeld aus, das von dem Magnetfeldsensor erfasst werden kann, der räumlich diesen beiden Segmenten und damit dem von den beiden Segmenten eingeschlossenen leiterfreien Bereich zugeordnet ist. Durch die Erfassung des Gradientenfeldes anstelle der Erfassung z.B. des Magnetfeldes eines der beiden Segmente wird eine Beeinflussung oder Verfälschung der Messung durch externe Magnetfelder verhindert oder weitestgehend reduziert.

Insofern weisen speziell Magnetfeldsensoren in ihrer Ausführungsform als GMR-Sensor, die auf einem feldrichtungsabhängigen Wirkprinzip beruhen, für die Anwendung als Stromsensoren Vorteile auf, weil sie zum einen gegenüber großen Magnetfeldern extrem stabil sind und zum anderen das Wirkprinzip der Magnetfeldrichtungs-Abhängigkeit durch eine bestimmte Anordnung mehrerer Einzel-Sensoren zu einer Brückenschaltung (Gradienten-Feldsensor) ausgenutzt werden kann, um eine hohe Unempfindlichkeit gegenüber externen Störfeldern zu erreichen.

Um den Stromfluss durch den Leiterabschnitt entlang des U-Turns sicherzustellen und um eine eventuelle Beschädigung des Magnetfeldsensors sowie der dem Magnetfeldsensor gegebenenfalls zugeordneten Auswerteelektronik zu verhindern, ist bevorzugt vorgesehen, dass der Magnetfeldsensor auf eine auf dem Leiterabschnitt, insbesondere im Bereich des U-Turns, also z.B. in einer beide Segmente erfassenden Art und Weise, vorgesehenen Isolierschicht aufgebracht ist.

Weiter bevorzugt ist auf dem Magnetfeldsensor mit Isolierschicht eine Abdeckfolie vorgesehen. Eine solche Abdeckfolie kann in einer besonders bevorzugten Ausgestaltung freigelegte Pads, also Kontaktstellen, aufweisen, wobei die oder jede Kontaktstelle durch ein Kontaktelement kontaktiert oder kontaktierbar ist, das auch zur Kontaktierung und Justierung des Magnetfeldsensors wirksam ist.

Eine bevorzugte, kostengünstige und dauerhafte Möglichkeit zum Verbinden der Isolierschicht und/oder der Abdeckfolie mit dem Leiterabschnitt bzw. dem jeweiligen Sensor besteht darin, dass diese durch Kleben, Aufprägen oder Ähnliches, z. B. Laminieren, miteinander kombiniert sind.

Die Isolierschicht ist bevorzugt als Isolierfolie ausgeführt, wobei als Material z.B. Polyimid in Betracht kommt. Eine weitere Alternative für die Ausführung der Isolierschicht besteht in Form eines Keramik-Substrats. Alternativ zum Verbinden des Magnetfeldsensors und damit direkt oder indirekt verbundener Komponenten mit dem Leiterabschnitt durch Kleben, Aufprägen oder dergleichen ist vorgesehen, dass der Leiterabschnitt zur Justierung des Magnetfeldsensors, insbesondere zur Justierung des Magnetfeldsensors mit Isolierschicht und/oder Abdeckfolie, eine Justiervorrichtung, z.B. in Form von auf der Oberfläche des Leiterabschnitts vorgesehenen oder aufgebrachten Erhöhungen, die in ihrer Orientierung und in ihrem Abstand zueinander auf die Abmessungen des Magnetfeldsensors und/oder der Isolierschicht bzw. Abdeckfolie abgestimmt sind, aufweist.

Bei einer solchen Justierung des Magnetfeldsensors ist gemäß einer weiteren vorteilhaften Ausführungsform vorgesehen, dass eine Fixierung eines durch die Justiervorrichtung justierten Magnetfeldsensors durch ein Federelement oder dergleichen erfolgt.

Die mit der Anmeldung eingereichten Patentansprüche sind Formulierungsvorschläge ohne Präjudiz für die Erzielung weitergehenden Patentschutzes. Die Anmelderin behält sich vor, noch weitere, bisher nur in der Beschreibung und/oder Zeichnung offenbarte Merkmalskombination zu beanspruchen.

Das oder jedes Ausführungsbeispiel ist nicht als Einschränkung der Erfindung zu verstehen. Vielmehr sind im Rahmen der vorliegenden Offenbarung zahlreiche Abänderungen und Modifikationen möglich, insbesondere solche Varianten, Elemente und Kombinationen und/oder Materialien, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen bzw. Elementen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen, auch soweit sie Herstell-, Prüf- und Arbeitsverfahren betreffen.

In Unteransprüchen verwendete Rückbeziehungen weisen auf die weitere Ausbildung des Gegenstandes des Hauptanspruches durch die Merkmale des jeweiligen Unteranspruches hin; sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Da die Gegenstände der Unteransprüche im Hinblick auf den Stand der Technik am Prioritätstag eigene und unabhängige Erfindungen bilden können, behält die Anmelderin sich vor, sie zum Gegenstand unabhängiger Ansprüche oder Teilungserklärungen zu machen. Sie können weiterhin auch selbständige Erfindungen enthalten, die eine von den Gegenständen der vorhergehenden Unteransprüche unabhängige Gestaltung aufweisen.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Darin zeigen
- FIG 1: einen geschlitzten Leiterabschnitt,
- FIG 2: eine Prinzipdarstellung des geschlitzten Leiterabschnitts,
- FIG 3 und FIG 4: einen geschlitzten Leiterabschnitt mit einem Magnetfeldsensor,
- FIG 5, FIG 6 und FIG 7: spezielle Ausführungs- und Anbringungsformen des Magnetfeldsensors.

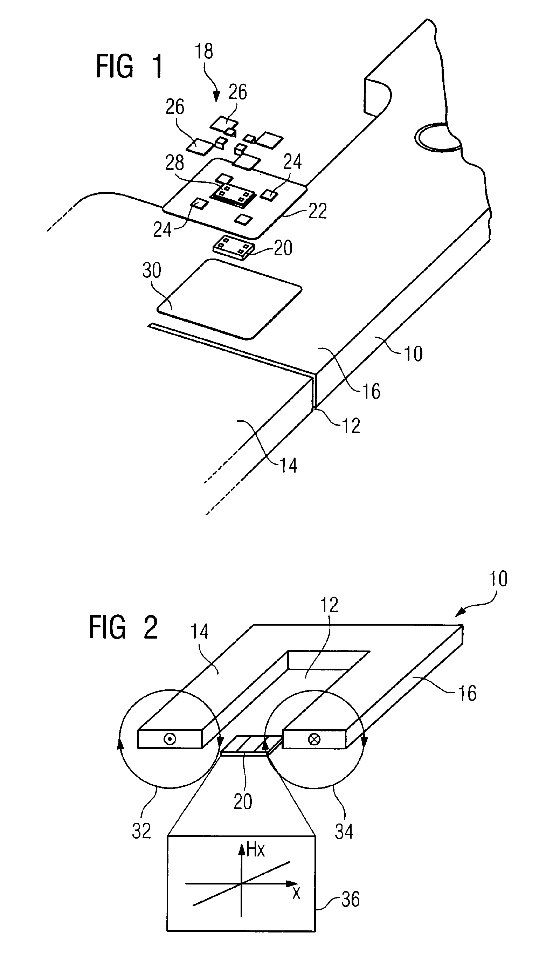

FIG 1 zeigt in perspektivischer Darstellung einen Teil eines Leiterabschnitts 10, der einen Schlitz 12 aufweist. Aufgrund der geschlitzten Form bildet der Leiter oder Leiterabschnitt 10 im Bereich des Schlitzes 12 ein erstes Segment 14 und ein zweites Segment 16 aus, die parallel oder, insbesondere bei anderen Formen des Schlitzes 12, zumindest im Wesentlichen parallel zueinander orientiert sind. Dem Schlitz 12 oder dem ersten und zweiten Abschnitt 14, 16 ist ein insgesamt mit 18 bezeichneter Magnetfeldsensor zugeordnet, der in FIG 1 zur Verbesserung der Übersichtlichkeit in einer Explosionsdarstellung gezeigt ist. Der Magnetfeldsensor 18 umfasst als sensorisch wirksames Element einen GMR-Sensor 20, der in eine Abdeckfolie 22 integriert ist. Die Abdeckfolie 22 weist freigelegte Pads 24 als Kontaktstellen auf. Jedes Pad 24 ist mit einem Kontaktelement 26 kontaktierbar, das auch zur Kontaktierung sowie ggf. zusätzlich zur Justierung des GMR-Sensors wirksam ist. Zur Aufnahme des GMR-Sensors 20 weist die Abdeckfolie 22 eine auf dessen Dimension abgestimmte Ausnehmung 28 auf. Zur Isolierung des Magnetfeldsensors 18 gegenüber dem Leiterabschnitt 10 ist eine Isolierschicht 30 vorgesehen.

FIG 2 zeigt in schematisch stark vereinfachter Form eine Prinzipdarstellung des Leiterabschnitts 10 mit den beiden Segmenten 14, 16. Der für die Strommessung relevante Teil des Leiterabschnitts 10 ist in FIG 2 als U-förmiges Element dargestellt, wobei die beiden Segmente 14, 16 die seitlichen Schenkel eines solchen U-förmigen Elementes bilden. Entsprechend wird der diesbezügliche Teil des Leiterabschnitts 10 auch als "U-Turn" bezeichnet.

In dem Bereich des U-Turns verläuft, wie durch die Pfeile in den beiden Segmenten 14, 16 angedeutet ist, der Strom in zueinander entgegengesetzten Richtungen. Entsprechend ergibt sich in dem von den beiden Segmenten 14, 16 eingeschlossenen leiterfreien Abschnitt, dem Schlitz 12, auch eine gegenläufige Orientierung der Feldlinien 32, 34 des magnetischen Feldes. In dem von den beiden Segmenten 14, 16 eingeschlossenen leiterfreien Abschnitt bildet sich also ein Gradientenfeld aus, das in dem in FIG 2 dargestellten Koordinatensystem 36 veranschaulicht ist. Der GMR-Sensor 20 als sensorisch wirksames Element des Magnetfeldsensors 18 (vergleiche FIG 1) ist zur Erfassung dieses Magnetfelds als Gradienten-Feldsensor ausgeführt, bei dem in an sich bekannter Art und Weise eine Mehrzahl von, insbesondere vier, von GMR-Sensoren in einer Brückenschaltung kombiniert sind.

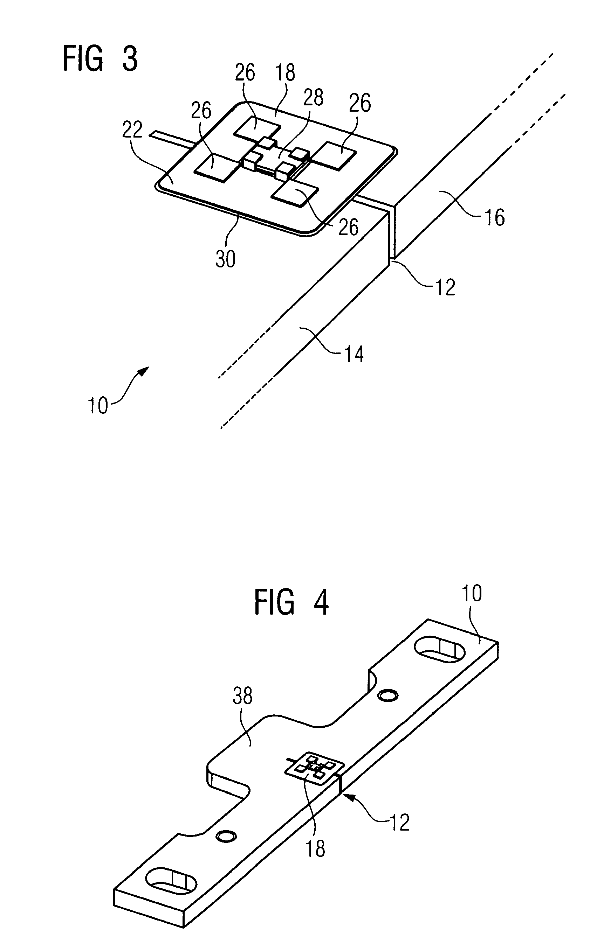

FIG 3 zeigt eine Darstellung der Situation gemäß FIG 1 mit auf dem Leiter 10 in Bereich der Segmente 14, 16 angebrachtem Magnetfeldsensor 18, wobei dessen als sensorisch wirksames Element fungierender GMR-Sensor 20 so angeordnet ist, dass er einen zwischen den beiden Segmenten 14, 16 verbleibenden Schlitz 12 überdeckt und insoweit zur Erfassung des sich in dem Schlitz 12 ausbildenden Gradientenfeldes geeignet ist.

FIG 4 zeigt die Situation gemäß FIG 3, wobei der Leiter 10 vollständig gezeigt ist. Man erkennt insbesondere in der Darstellung von FIG 4, dass im Bereich des sich um den Schlitz 12 ergebenden U-Turns der Leiter 10 eine Art "Verstärkung" 38 aufweist, die vorgesehen ist, damit zur Gewährleistung einer ausreichenden Stromtragfähigkeit der Leiter 10 auch im Bereich des U-Turns, also angrenzend an den Schlitz 12, einen stets gleich bleibenden oder zumindest in Wesentlichen gleich bleibenden Leiterquerschnitt aufweist.

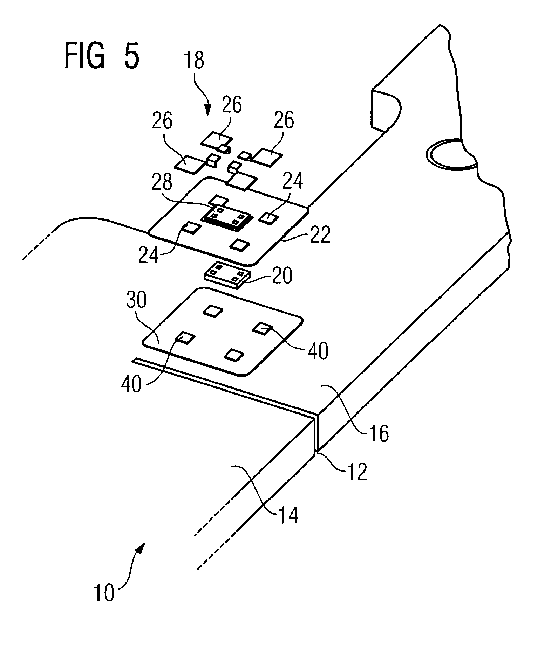

FIG 5 zeigt eine alternative Ausführungsform, bei der die Isolierschicht 30 als Keramiksubstrat mit insbesondere in Kupfer ausgeführten Pads 40 realisiert ist. Die Abdeckfolie 22 mit den dort freigelegten Pads 24 ist insbesondere nach der so genannten SIPLIT-Technologie hergestellt.

Die SIPLIT-Technologie ist z.B. in der WO 2004 077548 oder DE 10147935, DE 10308977, DE 10308978.0, DE 10 2004 040 773 beschrieben und für weitere Erläuterungen wird auf diese Dokumente sowie auf Dokumente in denselben oder parallelen Patentfamilien verwiesen, deren vollständiger Offenbarungsgehalt hinsichtlich der SIPLIT-Technologie hiermit in diese Anmeldung einbezogen wird.

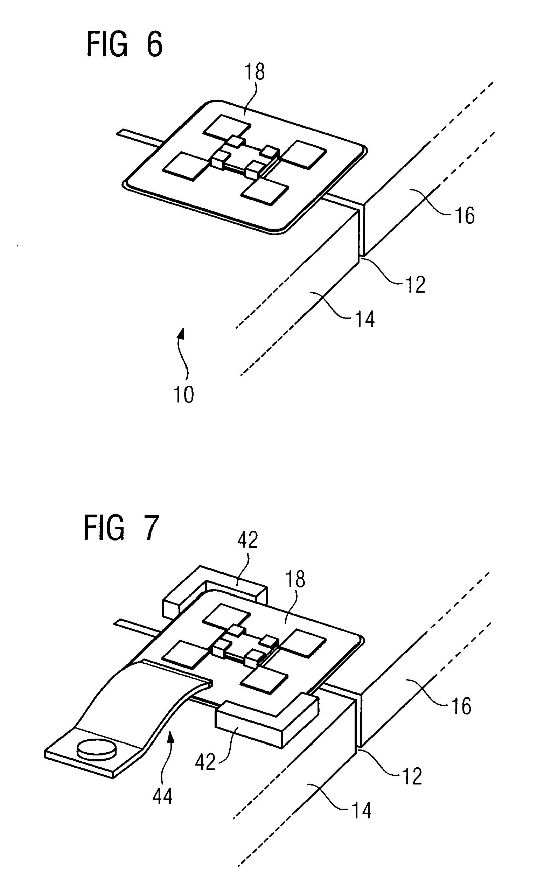

FIG 6 zeigt einen Magnetfeldsensor 18, der im Bereich des zwischen den beiden Segmenten 14, 16 verbleibenden Schlitzes 12 auf dem Leiter 10 durch Verkleben oder ähnliche Befestigungsverfahren angebracht ist.

FIG 7 zeigt eine dazu alternative Ausführungsform, bei der der Leiter 10 im Bereich der Segmente 14, 16 eine Justiervorrichtung 42 in Form zweier winkliger Erhebungen aufweist, die auf der Oberfläche des Leiters oder Leiterabschnitts 10 aufgebracht oder vorgesehen sind, insbesondere einstückig mit dem Leiter 10 verbunden sind, und die in ihrer Orientierung und in ihrem Abstand zueinander auf die Abmessungen des Magnetfeldsensors 18 abgestimmt sind. Die Justiervorrichtung 42 verhindert eine unerwünschte Bewegung des Magnetfeldsensors 18 auf der Oberfläche des Leiters 10. Zur weiteren Fixierung des Magnetfeldsensors 18 in seiner durch die Justiervorrichtung 42 vorgegebenen Position ist ein Federelement 44, z.B. in Form einer Blechlasche, vorgesehen, das auf zumindest eine Oberfläche des Magnetfeldsensors eine Kraft ausübt, so dass der Magnetfeldsensor 18 insgesamt durch das Zusammenspiel von Justiervorrichtung 42 und Federelement 44 in seiner Position fixiert ist.

Zusammenfassend lässt sich damit die vorliegende Erfindung kurz wie folgt beschreiben: Es wird eine Stromerfassungsvorrichtung mit einem als Stromsensor fungierenden Magnetfeldsensor 18 angegeben, bei der ein zur Stromerfassungsvorrichtung gehöriger Leiter 10 oder Leiterabschnitt 10, dem der Magnetfeldsensor 18 zugeordnet ist, zumindest einen Bereich umfasst, in dem ein erstes Segment 14 und ein zweites Segment 16 des Leiters oder Leiterabschnitts 10 parallel oder zumindest im Wesentlichen parallel zueinander orientiert sind, so dass sich in einem Bereich zwischen diesen beiden Segmenten 14, 16 ein leiterfreier Bereich ergibt, in dem sich bei Stromfluss durch den Leiter 10 ein Gradientenfeld ausbildet, das von dem Magnetfeldsensor 18, der räumlich sowohl diesem ersten und zweiten Segment 14, 16 zugeordnet ist, erfasst wird oder erfassbar ist.

## Patentansprüche

1. Stromerfassungsvorrichtung mit einem Magnetfeldsensor,
**gekennzeichnet durch**
einen zur Stromerfassungsvorrichtung gehörigen Leiter oder Leiterabschnitt (10), dem der Magnetfeldsensor zugeordnet ist,
wobei der Leiterabschnitt (10) zumindest einen Bereich umfasst, in dem ein erstes Segment (14) und ein zweites Segment (16) des Leiterabschnitts (10) parallel oder zumindest in Wesentlichen parallel zueinander orientiert sind und
wobei der Magnetfeldsensor (18) räumlich sowohl diesem ersten und zweiten Segment (14, 16) des Leiterabschnitts (10) zugeordnet ist.

2. Stromerfassungsvorrichtung nach Anspruch 1,
wobei der Magnetfeldsensor (18) als sensorisch wirksames Element einen GMR-Sensor (20) umfasst.

3. Stromerfassungsvorrichtung nach Anspruch 1 oder 2,
wobei das erste und zweite Segment (14, 16) durch einen Schlitz (12) im Leiterabschnitt (10) gebildet wird.

4. Stromerfassungsvorrichtung nach einem der vorangehenden Ansprüche, wobei der Magnetfeldsensor (18) auf einer auf dem Leiterabschnitt (10) vorgesehenen Isolierschicht (30) aufgebracht ist.

5. Stromerfassungsvorrichtung nach Anspruch 4,
wobei auf dem Magnetfeldsensor (18) mit Isolierschicht (30) eine Abdeckfolie (22) vorgesehen ist.

6. Stromerfassungsvorrichtung nach Anspruch 5,
wobei die Abdeckfolie (22) freigelegte Pads (24) als Kontaktstellen aufweist und wobei die oder jede Kontaktstelle durch ein Kontaktelement (26) kontaktiert ist, das auch zur Kontaktierung und Justierung des Magnetfeldsensors (18) wirksam ist.

7. Stromerfassungsvorrichtung nach Anspruch 4, 5 oder 6,
wobei die Isolierschicht (30) und/oder die Abdeckfolie (22) durch Kleben oder Aufprägen mit dem Leiterabschnitt (10) bzw. der Isolierschicht verbunden sind.

8. Stromerfassungsvorrichtung nach Anspruch 4, 5, 6 oder 7,
wobei die Isolierschicht (30) eine Isolierfolie, insbesondere aus Polyimid oder ein Keramik-Substrat ist.

9. Stromerfassungsvorrichtung nach einem der vorangehenden Ansprüche, wobei der Leiterabschnitt (10) zur Justierung des Magnetfeldsensors (18), insbesondere des Magnetfeldsensors (18) mit Isolierschicht (30) und/oder Abdeckfolie (22), eine Justiervorrichtung (42) aufweist.

10. Stromerfassungsvorrichtung nach Anspruch 9,
wobei zur Fixierung eines durch die Justiervorrichtung (42) justierten Magnetfeldsensors (18), insbesondere Magnetfeldsensor (18) mit Isolierschicht (30) und/oder Abdeckfolie (22), ein Federelement vorgesehen ist.
